# EUROPEAN PATENT APPLICATION

(11) **EP 4 697 909 A1**
(43) Date of publication of application: **18.02.2026**
(21) Application number: 24937304.4
(22) Date of filing: 26.11.2024
(51) Int. Cl.: H10K 30/88

(54) **ENCAPSULATED PEROVSKITE SOLAR CELL MODULE AND PREPARATION METHOD**

(30) Priority: 24.06.2024 CN 202410818454
(71) Applicant: Xi'an TJ-Solar New Energy Co., Ltd, Xianyang, Shaanxi 712046 (CN)
(72) Inventor: ZHAO, Chnagzheng, Xianyang, Shaanxi 712046 (CN); LI, Peizhou, Xianyang, Shaanxi 712046 (CN); HAN, Wei, Xianyang, Shaanxi 712046 (CN)
(74) Representative: Berggren Oy
(86) International application number: PCT/CN2024/134604
(87) International publication number: WO 2026/000805

(57) **Abstract**

The present invention relates to the technical field of perovskite cells, and particularly to an encapsulated perovskite solar cell module and a preparation method. The encapsulated perovskite solar cell module includes a substrate, a perovskite solar cell module, and an encapsulation component sequentially stacked from bottom to top, wherein a lower surface of the encapsulation component is in contact with an upper surface of the substrate to form an encapsulated structure, and the perovskite solar cell module is located within the encapsulated structure; and the encapsulation component includes at least two inorganic layers and at least one organic layer, the at least two inorganic layers and the at least one organic layer are alternately stacked, and an outermost layer of the encapsulation component is one of at least two inorganic layers, each of the at least one organic layer is made of an organic molecular material through an evaporation process. The encapsulation component of the present invention can improve the encapsulating effect of perovskite solar cell devices, solving the problem of decomposition of the perovskite solar cells in high-humidity, high-temperature, or oxygen-rich environments.

## Description

### Technical Field

The present invention relates to the technical field of perovskite cells, and particularly to an encapsulated perovskite solar cell module and a preparation method.

### Background

Among the third-generation solar cell technologies, perovskite solar cells have attracted widespread attention due to their low cost and high efficiency. On the path to the industrialization of perovskite solar cells, module stability has long been an overlooked problem.

Then, perovskite solar cells undergo varying degrees of decomposition, especially in high-humidity, high-temperature or oxygen-rich environments, the decomposition of perovskite will be accelerated, and its decay is particularly serious. Therefore, how to improve the stability of perovskite solar cell modules has become an urgent problem to be solved.

In view of this, the inventors provide an encapsulated perovskite solar cell module and a preparation method to solve the technical problem above.

### Summary

An object of the present invention is to overcome the shortcomings of the prior art as described above and propose an encapsulated perovskite solar cell module and a preparation method of an encapsulation component. The cell module is provided with an encapsulation component, solving the problem of decomposition of the perovskite solar cells in high-humidity, high-temperature, or oxygen-rich environments.

To achieve the object above, the present invention adopts the following technical solutions.

In one aspect, the present invention provides an encapsulated perovskite solar cell module, including a substrate, a perovskite solar cell module, and an encapsulation component sequentially stacked from bottom to top, wherein a lower surface of the encapsulation component is in contact with an upper surface of the substrate to form an encapsulated structure, and the perovskite solar cell module is located within the encapsulated structure; and
the encapsulation component includes at least two inorganic layers and at least one organic layer, the at least two inorganic layers and the at least one organic layer are alternately stacked, and an outermost layer of the encapsulation component is one of the at least two inorganic layers,
wherein each of the at least one organic layer is made of an organic molecular material through an evaporation process.

Further particularly, the substrate is not limited in the present invention and any conductive substrate known in the art is used, as long as the object of the present invention can be achieved. The substrate is selected from fluorine-doped tin oxide (FTO) or indium-doped tin oxide (ITO).

Further, a total number of layers of the encapsulation component is N layers, N being an odd number, and 3 ≤ N ≤ 17.

In particular, the organic layer is an organic thin film.

It is to be noted that the encapsulation component includes any number of organic thin films and inorganic layers within the range above. The total number of combined layers of the organic thin film and the inorganic layer can be flexibly set according to the actual barrier properties of the perovskite solar cell module to oxygen, moisture, water vapor, and/or chemicals.

In particular, the total number of layers of the organic thin film and the inorganic layer is 3 layers, 5 layers, 7 layers, 9 layers, 11 layers, 13 layers, 15 layers, or 17 layers. When the total number of layers of the organic thin film and the inorganic layer is 5 layers, a first inorganic layer, a second inorganic layer, a third inorganic layer, a first organic thin film, and a second organic thin film are included. The first inorganic layer, the first organic thin film, the second inorganic layer, the second organic thin film, and the third inorganic layer are sequentially deposited from the inside to the outside.

It is to be noted that in the encapsulation component, the organic thin film and the inorganic layer are alternately deposited to supplement or strengthen the encapsulating effect of the perovskite solar cell module.

Further, each of the at least one organic layer has a thickness of 500 nm to 50 µm.

It is to be noted that the thickness of the single organic layer can be adaptively prepared according to actual encapsulating requirements. The optional thickness is in a range of 500 nm to 700 nm, 701 nm to 900 nm, 901 nm to 1 µm, 1.1 µm to 10 µm, 10.1 µm to 20 µm, 20.1 µm to 30 µm, 30.1 µm to 40 µm, 40.1 µm to 50 µm, and the like, which are not exhaustively listed here.

Further, compounds included in the organic molecular material all contain heteroatoms, the heteroatoms being at least one of N and O; and
the compounds include 8-hydroxyquinoline aluminum (CAS: 2085-33-8), 9-dimethyl-4,7-diphenyl-1,10-phenanthroline (CAS: 4733-39-5), 1,3,5-tris(1-phenyl-1H-benzimidazol-2-yl)benzene (CAS: 192198-85-9), 2-(4-biphenyl)-5-phenyloxadiazole (CAS: 852-38-0), 6-fluoro-2-(2'-fluoro-[1,1'-biphenyl]-4-yl)-3-methylquinoline-4-carboxylic acid (CAS: 96187-53-0), and at least one of the following formulas 1 to 6.

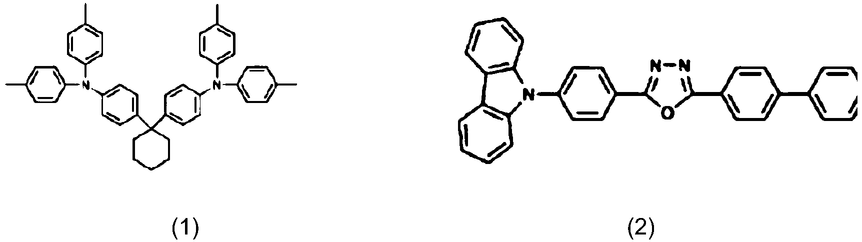

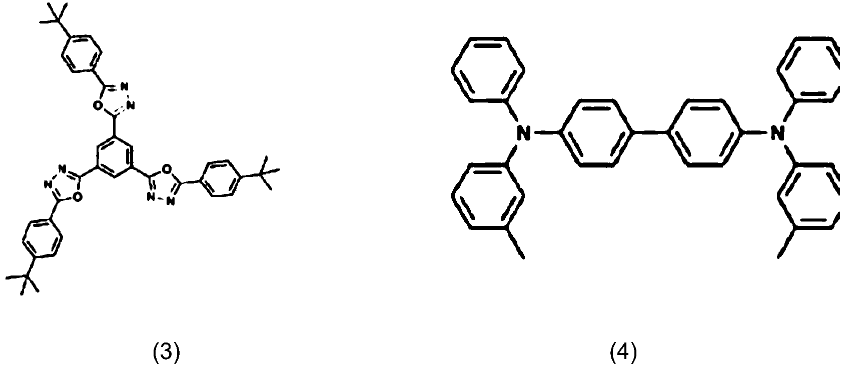

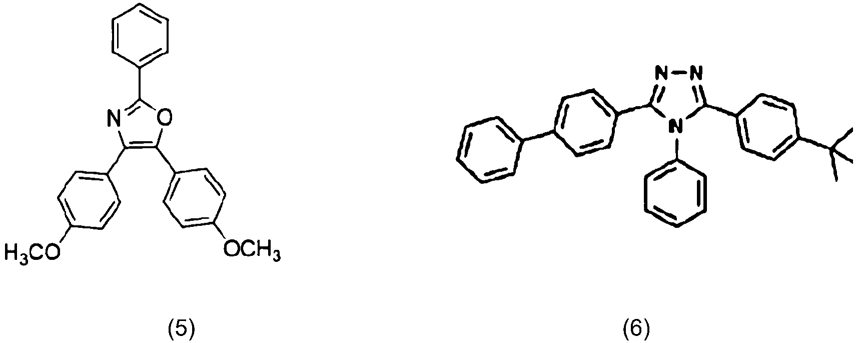

Further, each of the at least one inorganic layer is made of at least one of silicon oxide (Siₓ₁O_{y1}), silicon nitride (Siₓ₂N_{y2}), silicon oxynitride (SiOₓ₃N_{y3}), zinc oxide (ZnO), antimony trioxide (Sb₂O₃), aluminum oxide (Alₓ₄O_{y4}), indium oxide (In₂O₃), or tin oxide (SnO₂), x1, x2, x3, x4, y1, y2, y3, and y4 being all integers in a range of 1 to 5.

Further, an outermost layer of the encapsulation component is an inorganic layer, and each of the at least two inorganic layers has a thickness of 5 nm to 10 µm. When the thickness of the inorganic layer is less than 5 nm, the moisture and oxygen barrier properties of the inorganic layer deteriorates, and when the thickness of the inorganic layer is more than 10 µm, excessive stress can develop in the inorganic layer, making it prone to cracking subsequently.

It is to be noted that the thickness of the single inorganic layer can be adaptively prepared according to actual encapsulating requirements. The optional thickness is in a range of 5 nm to 20 nm, 21 nm to 40 nm, 41 nm to 80 nm, 81 nm to 100 nm, 101 nm to 300 nm, 301 nm to 500 nm, 501 nm to 700 nm, 701 nm to 900 nm, 901 nm to 1000 nm, 1.1 µm to 2 µm, 2.1 µm to 4 µm, 4.1 µm to 6 µm, 6.1 µm to 8 µm, 8.1 µm to 10 µm, and the like, which are not exhaustively listed here.

Further, the perovskite solar cell module includes: a hole transport layer, a perovskite layer, an electron transport layer, and a metal electrode layer sequentially stacked from bottom to top, a lower surface of the hole transport layer being in contact with the upper surface of the substrate; or
an electron transport layer, a perovskite layer, a hole transport layer, and a metal electrode layer sequentially stacked from bottom to top, a lower surface of the electron transport layer being in contact with the upper surface of the substrate,
wherein one of the at least two inorganic layers on the outermost layer of the encapsulation component is disposed on a top of the metal electrode layer, and a lower surface of the one of the at least two inorganic layers on the outermost layer of the encapsulation component is in contact with the upper surface of the substrate, to encapsulate the perovskite solar cell module.

Further, the perovskite solar cell of the present invention can further include additional layers, particularly a passivation layer or the like.

Further particularly, the material of the electron transport layer is not limited in the present invention, which is a material or a combination of materials known to those skilled in the art, as long as the object of the present invention can be achieved. The electron transport layer is selected from a titanium dioxide (TiO₂) electron transport layer, a tin dioxide (SnO₂) electron transport layer, a zinc oxide (ZnO) electron transport layer, and the like. Furthermore, the preparation process of the electron transport layer is not limited in the present invention, which is prepared by a solution spin coating, a solution blade coating, a solution spray coating, a slot-die coating, a hydrothermal growth, or the like.

Further particularly, the material of the perovskite layer is not limited in the present invention, which is a material or a combination of materials known to those skilled in the art, as long as the object of the present invention can be achieved. The perovskite layer includes a perovskite material with an ABO₃-type structure, and the perovskite material is selected from any one of CH₃NH₃PbBr₃, CH₃NH₃PbI₃, CH₃NH₃PbI₂Cl, and CH₃NH₃Pb(I₁₋ₓBrₓ)₃, wherein 0 ≤ x ≤ 1. The preparation process of the perovskite layer is not limited in the present invention, which is prepared by a solution spin coating, a solution blade coating, a solution spray coating, a slot-die coating, a vapor coating method, or the like.

Further particularly, the material of the hole transport layer is not limited in the present invention, which is a material or a combination of materials known to those skilled in the art, as long as the object of the present invention can be achieved. The hole transport layer is a layered structure prepared by any one of nickel oxide, doped nickel oxide, cuprous iodide, cuprous thiocyanate, poly [bis (4-phenyl) (2,4,6-trimethylphenyl) amine] (PTAA), PEDOT: PSS, or Spiro-OMeTAD. The thickness of the hole transport layer is not limited in the present invention, as long as the object of the present invention can be achieved, and preferably, the hole transport layer has a thickness of 10 nm to 100 nm. In addition, the preparation process of the hole transport layer is not limited in the present invention, as long as the object of the present invention can be achieved, which is prepared by a solution spin coating, a solution blade coating, a slot-die coating, a vapor phase method, or the like.

Further particularly, the material of the metal electrode layer is not limited in the present invention, which is a material or a combination of materials known to those skilled in the art, as long as the object of the present invention can be achieved. The metal electrode layer is any one of a gold (Au) electrode, a silver (Ag) electrode, an aluminum (Al) electrode, or a copper (Cu) electrode. Furthermore, the thickness of the metal electrode layer is not limited in the present invention, as long as the object of the present invention can be achieved, preferably, the metal electrode layer has a thickness of 50 nm to 100 nm, and a better effect can be obtained when the thickness of the metal electrode layer is within this range. Certainly, those skilled in the art can select a suitable thickness of the metal electrode layer as needed. In addition, the preparation process of the metal electrode layer is not limited in the present invention, as long as the object of the present invention can be achieved, which is prepared by a thermal evaporation method.

In another aspect, the present invention further provides a preparation method of an encapsulation component, which, on the basis of the encapsulated perovskite solar cell module above, includes: performing deposition and coating on a top of the perovskite solar cell module in an alternating form of inorganic layer-organic layer-inorganic layer, with an outermost layer being an inorganic layer, the inorganic layer and the organic layerfinally deposited and coated on a surface of the perovskite solar cell module is the encapsulation component.

Further, each of the inorganic layers is formed by depositing and coating a material of the inorganic layer on the surface of the perovskite solar cell module through a plasma deposition process or a vacuum deposition process.

In particular, the plasma deposition process or the vacuum deposition process includes sputtering, chemical vapor deposition (CVD), plasma enhanced chemical vapor deposition (PECVD), evaporation, sublimation, electron cyclotron resonance-plasma enhanced chemical vapor deposition (ECR-PECVD), and a combination thereof.

Further, the organic layer is prepared by depositing and coating an organic molecular material on a surface of one of the inorganic layers through an evaporation process to form an organic thin film,
wherein during the evaporation process, an evaporation speed is 0.1 Å/s to 5 Å/s, and an evaporation temperature is 150°C to 400°C.

The adhesion between the inorganic layer and the organic thin film of the present invention is very important. If the adhesion is insufficient, it can easily lead to defects at the interface between the inorganic layer and the organic thin film, resulting in a poor encapsulating effect. Moreover, due to the stress problem of the inorganic layer, cracking of the inorganic layer and separation between the inorganic layer and the organic thin film can occur. Therefore, the organic molecular material selected in the present invention not only has good uniformity and film-forming stability during thin film deposition by evaporation, which is beneficial to relieve the stress of the inorganic layer and compensate for the defects of the inorganic layer, but also exhibits excellent adhesion with the inorganic layer, thereby improving the long-term stability of the perovskite solar cell module.

Compared to the prior art, the present invention has the following advantageous effects:
(1) The present invention provides an encapsulated perovskite solar cell module, in which an encapsulation component is disposed on the surface of the perovskite solar cell module. The encapsulation component includes an inorganic layer and an organic layer that are alternately stacked. The organic layer is an organic thin film prepared by evaporating an organic molecular material. The organic thin film features a large spatial structure, good uniformity, and film-forming stability, as well as an excellent film-forming morphology, which can improve the encapsulating effect of the perovskite solar cell module.
(2) The present invention adopts organic molecular materials containing nitrogen atoms and/or oxygen atoms, which can effectively improve the adhesive between the prepared organic thin film and the inorganic layer.
(3) The preparation method of an encapsulation component according to the present invention involves preparing an organic thin film using an evaporation process on an organic molecular material onto the inorganic layer. The organic thin film is beneficial to buffer stress, compensate for the defects of the inorganic layer, and also to improve the encapsulating quality, surface morphology, and encapsulating effect. Furthermore, the preparation method provides a feasible implementation solution for the large-scale preparation of encapsulated perovskite solar cell modules.

### Brief Description of the Drawings

The drawings herein are incorporated into and constitute part of the description, and together with the description, serve to explain the principles of the present invention.

To explain the examples of the present invention or the technical solutions in the prior art more clearly, the drawings to be used in the examples or in the description of the prior art are briefly introduced below. It is obvious that those ordinarily skilled in the art would have been able to obtain other drawings according to these drawings without paying any creative labor.
FIG. 1 is a schematic cross-sectional diagram of an encapsulated perovskite solar cell module in Example 1 of the present invention;
FIG. 2 is a schematic cross-sectional diagram of an encapsulated perovskite solar cell module in Example 4;
FIG. 3 is a schematic cross-sectional diagram of an encapsulated perovskite solar cell module in Comparative Example 2;
FIG. 4 is a performance test PCE-t curve of encapsulated perovskite solar cell modules prepared in Examples 1 to 4; and
FIG. 5 is a performance test PCE-t curve of encapsulated perovskite solar cell modules prepared in Example 1 and Comparative Examples 1 to 2.

In the drawings: 10, substrate; 20, perovskite solar cell module; 30, encapsulation component; 31, first inorganic layer; 32, first organic thin film; 33, second inorganic layer; 34, second organic thin film; and 35, third inorganic layer.

### Detailed Description of the Embodiments

Exemplary embodiments are described in detail herein, and the embodiments described in the following exemplary embodiments do not represent all embodiments consistent with the present invention. Rather, the embodiments described are merely examples consistent with some aspects of the present invention as detailed in the appended claims.

### Example 1

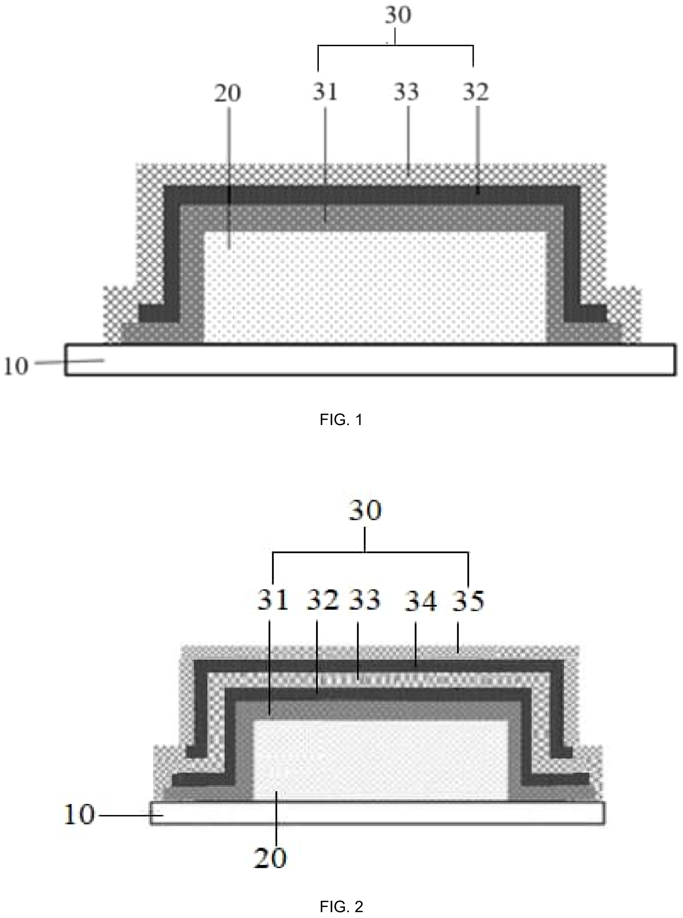

Referring to FIG. 1, the present invention provides an encapsulated perovskite solar cell module, including a substrate 10, a perovskite solar cell module 20, and an encapsulation component 30 sequentially stacked from bottom to top, wherein a lower surface of the encapsulation component 30 is in contact with an upper surface of the substrate 10 to form an encapsulated structure, and the perovskite solar cell module 20 is located within the encapsulated structure.

The encapsulation component 30 includes at least two inorganic layers and at least one organic layer, the at least two inorganic layers and the at least one organic layer are alternately stacked, and an outermost layer of the encapsulation component 30 is one of the at least two inorganic layers.

Each of the at least one organic layer is made of an organic molecular material through an evaporation process, particularly an organic thin film.

In the example, the total number of layers of the encapsulation component 30 is 3 layers, including a first inorganic layer 31, a first organic thin film 32, and a second inorganic layer 33 sequentially deposited from the inside to the outside, as shown in FIG. 1.

The first inorganic layer 31 has a thickness of 5 µm, the second inorganic layer 33 has a thickness of 4 µm, and the first inorganic layer 31 and the second inorganic layer 33 are each made of silicon oxynitride (SiON). The first organic thin film 32 is made of 8-hydroxyquinoline aluminum (CAS: 2085-33-8) and has a thickness of 800 nm.

Further, the perovskite solar cell module 20 includes an electron transport layer, a perovskite layer, a hole transport layer, and a metal electrode layer sequentially stacked from bottom to top, a lower surface of the electron transport layer being in contact with the upper surface of the substrate 10.

The first inorganic layer 31 is disposed on the top of the metal electrode layer, and a lower surface of the first inorganic layer 31 is in contact with the upper surface of the substrate 10, to encapsulate the perovskite solar cell module 20.

In particular, in the example, the substrate 10 is an ITO conductive glass substrate. The substrate is pretreated, including sequentially ultrasonically cleaning the ITO conductive glass substrate with an ITO cleaning agent, water, a mixed solution of ethanol and acetone (Vₑₜₕₐₙₒₗ:V_{acetone} = 1:1), and water, followed by drying with a nitrogen gun and performing UV-ozone treatment for 10 min.

In the example, the preparation of the electron transport layer includes: (1) An ethanol solution of mesoporous titanium dioxide is prepared by mixing titanium dioxide slurry and ethanol at a mass fraction ratio of 1:5, followed by ultrasonicating the ethanol solution of mesoporous titanium dioxide for 30 min to obtain a precursor solution. (2) 100 µL of the precursor solution is taken to spin-coat onto the surface of the pretreated ITO conductive glass substrate, followed by transferring to a oven and heating at 70°C for 30 min. (3) Annealing is performed at 180°C for 30 min, followed by cool naturally to room temperature to obtain a titanium dioxide electron transport layer.

In the example, the preparation of the perovskite layer includes: (1) 760.65 mg of lead iodide (PbI₂), 246.9 mg of formamidinium hydroiodide (FAI), 12.5 mg of methylammonium bromide (MABr), 18.72 mg of cesium iodide (Csl), and 21.95 mg of methylammonium chloride are mixed and dissolved in 1 mL of a mixed solution of N,N-dimethylformamide and dimethyl sulfoxide (V_{N,N-dimethylformamide}:V_{dimethylsulfoxide} = 4:1), followed by stirring for 3 h to obtain a perovskite precursor solution. (2) The perovskite precursor solution is spin-coated onto the surface of the prepared titanium dioxide electron transport layer above, followed by solidification to form a thin film, thereby completing the preparation of the perovskite layer, wherein the spin-coating speed is 2000 rpm, and the spin-coating time is 10 s.

In the example, the preparation of the hole transport layer includes: (1) 90 mg of Spiro-OMeTAD, 28.5 µL of tributyl phosphate, 17.8 µL of a mixed solution of lithium bis(trifluoromethanesulfon)imide and acetonitrile (520 mg/mL Lithium bis (trifluoromethanesulfonyl) imide dissolved in acetonitrile), and 20 µL of a mixed solution of FK209 and acetonitrile (200 mg/mL FK209 dissolved in acetonitrile) are added into 1 mL of chlorobenzene, followed by stirring for 5 h to obtain a Spiro-OMeTAD precursor solution. (2) 28 µL of the Spiro-OMeTAD precursor solution is spin-coated onto the surface of the prepared perovskite layer above to obtain the hole transport layer, wherein the spin-coating speed is 3000 rpm, and the spin-coating time is 30 s.

In the example, the preparation of the metal electrode layer includes: an Au electrode is deposited on the surface of the prepared hole transport layer above using a thermal evaporation method, and the metal electrode layer has a thickness of 50 nm.

The examples of the present invention further provide a preparation method of an encapsulation component, which, on the basis of the encapsulated perovskite solar cell module of the example, includes: performing deposition and coating on a top of the perovskite solar cell module 20 in an alternating form of inorganic layer-organic layer-inorganic layer, with an outermost layer being an inorganic layer, the inorganic layer and the organic layer finally deposited and coated on a surface of the perovskite solar cell module 20 is the encapsulation component 30. The encapsulation component 30 of the example has 3 layers, including a first inorganic layer 31, a first organic thin film 32, and a second inorganic layer 33 sequentially deposited from the inside to the outside. The specific preparation process is as follows:

### Step I . Preparation of first inorganic layer 31

Silicon oxynitride (SiON) was deposited and coated on the surface of the metal electrode layer by chemical vapor deposition (CVD) to form the first inorganic layer 31.

### Step II. Preparation of first organic thin film 32

8-hydroxyquinoline aluminum material was deposited and coated on the surface of the first inorganic layer 31 through an evaporation process to form the first organic thin film 32, wherein the evaporation speed was 3 Å/s, and the evaporation temperature was 320°C.

### Step III. Preparation of second inorganic layer 33

Silicon oxynitride (SiON) was deposited and coated on the surface of the first organic thin film 32 by chemical vapor deposition (CVD) to form the second inorganic layer 33, that is, the encapsulation component 30 was prepared.

### Example 2

The example differs from Example 1 in that:
(1) The first inorganic layer 31 has a thickness of 10 µm, and the second inorganic layer 33 has a thickness of 5 µm. The first inorganic layer 31 is made of silicon nitride (Si₃N₄), and the second inorganic layer 33 is made of aluminum oxide (Al₂O₃).
(2) The perovskite solar cell module 20 includes a hole transport layer, a perovskite layer, an electron transport layer, and a metal electrode layer sequentially stacked from bottom to top, the lower surface of the hole transport layer being in contact with the upper surface of the substrate 10.

The first inorganic layer 31 is disposed on the top of the metal electrode layer, and a lower surface of the first inorganic layer 31 is in contact with the upper surface of the substrate 10, to encapsulate the perovskite solar cell module 20.

In particular, in the example, the substrate 10 is an ITO conductive glass substrate. The substrate is pretreated, including sequentially ultrasonically cleaning the ITO conductive glass substrate with an ITO cleaning agent, water, a mixed solution of ethanol and acetone (Vₑₜₕₐₙₒₗ:V_{acetone} = 1:1), and water, followed by drying with a nitrogen gun and performing UV-ozone treatment for 10 min.

In the example, the preparation of the hole transport layer includes: (1) 90 mg of Spiro-OMeTAD, 28.5 µL of tributyl phosphate, 17.8 µL of a mixed solution of Lithium bis (trifluoromethanesulfonyl) imide and acetonitrile (520 mg/mL Lithium bis (trifluoromethanesulfonyl) imide dissolved in acetonitrile), and 20 µL of a mixed solution of FK209 and acetonitrile (200 mg/mL FK209 dissolved in acetonitrile) are added into 1 mL of chlorobenzene, followed by stirring for 5 h to obtain a Spiro-OMeTAD precursor solution. (2) 28 µL of the Spiro-OMeTAD precursor solution is spin-coated onto the surface of the ITO conductive glass substrate to obtain the hole transport layer, wherein the spin-coating speed is 3000 rpm, and the spin-coating time is 30 s.

In the example, the preparation of the perovskite layer includes: (1) 760.65 mg of lead iodide (PbI₂), 246.9 mg of formamidinium hydroiodide (FAI), 12.5 mg of methylammonium bromide (MABr), 18.72 mg of cesium iodide (Csl), and 21.95 mg of methylammonium chloride are mixed and dissolved in 1 mL of a mixed solution of N,N-dimethylformamide and dimethyl sulfoxide (V_{N,N-dimethylformamide}:V_{dimethylsulfoxide} = 4:1), followed by stirring for 3 h to obtain a perovskite precursor solution. (2) The perovskite precursor solution is spin-coated onto the surface of the prepared hole transport layer above, followed by solidification to form a thin film, thereby completing the preparation of the perovskite layer, wherein the spin-coating speed is 2000 rpm, and the spin-coating time is 10 s.

In the example, the preparation of the electron transport layer includes: (1) An ethanol solution of mesoporous titanium dioxide is prepared by mixing titanium dioxide slurry and ethanol at a mass fraction ratio of 1:5, followed by ultrasonicating the ethanol solution of mesoporous titanium dioxide for 30 min to obtain a precursor solution. (2) 100 µL of the precursor solution is taken to spin-coat onto the surface of the pretreated perovskite layer above, followed by transferring to a oven and heating at 70 °C for 30 min. (3) Annealing is performed at 180 °C for 30 min, followed by cool naturally to room temperature to obtain a titanium dioxide electron transport layer.

In the example, the preparation of the metal electrode layer includes: an Au electrode is deposited on the surface of the prepared titanium dioxide electron transport layer above using a thermal evaporation method, and the metal electrode layer has a thickness of 50 nm.

(3) The examples of the present invention further provide a preparation method of an encapsulation component, which, on the basis of the encapsulated perovskite solar cell module of the example, includes: performing deposition and coating on a top of the perovskite solar cell module 20 in an alternating form of inorganic layer-organic layer-inorganic layer, with an outermost layer being an inorganic layer, the inorganic layer and the organic layer finally deposited and coated on a surface of the perovskite solar cell module 20 is the encapsulation component 30. The encapsulation component 30 of the example has 3 layers, including a first inorganic layer 31, a first organic thin film 32, and a second inorganic layer 33 sequentially deposited from the inside to the outside. The specific preparation process is as follows:

### Step I . Preparation of first inorganic layer 31

Silicon nitride (Si₃N₄) was deposited and coated on the surface of the metal electrode layer by chemical vapor deposition (CVD) to form the first inorganic layer 31.

### Step II. Preparation of first organic thin film 32

8-hydroxyquinoline aluminum (CAS: 2085-33-8) material was deposited and coated on the surface of the first inorganic layer 31 through an evaporation process to form the first organic thin film 32, wherein the evaporation speed was 0.1 Å/s, and the evaporation temperature was 150 °C.

### Step III. Preparation of second inorganic layer 33

Aluminum oxide (Al₂O₃) was deposited and coated on the surface of the first organic thin film 32 by chemical vapor deposition (CVD) to form the second inorganic layer 33, that is, the encapsulation component 30 was prepared.

### Example 3

The example differs from Example 1 in that:
(1) The first inorganic layer 31 has a thickness of 5 µm, and the second inorganic layer 33 has a thickness of 10 µm. The first inorganic layer 31 is made of a mixture of silicon oxide (SiO₂) and silicon nitride (Si₃N₄) in a mass ratio of 1:1, and the second inorganic layer 33 is made of aluminum oxide (Al₂O₃).

The first organic thin film 32 is made of a mixture of 9-dimethyl-4,7-diphenyl-1,10-phenanthroline (CAS: 4733-39-5) and 1,3,5-tris(1-phenyl-1H-benzimidazol-2-yl)benzene (CAS: 192198-85-9) in a mass ratio of 1:1, and the first organic thin film 32 has a thickness of 50 µm.

(2) The examples of the present invention further provide a preparation method of an encapsulation component, which, on the basis of the encapsulated perovskite solar cell module of the example, includes: performing deposition and coating on a top of the perovskite solar cell module 20 in an alternating form of inorganic layer-organic layer-inorganic layer, with an outermost layer being an inorganic layer, the inorganic layer and the organic layer finally deposited and coated on a surface of the perovskite solar cell module 20 is the encapsulation component 30. The encapsulation component 30 of the example has 3 layers, including a first inorganic layer 31, a first organic thin film 32, and a second inorganic layer 33 sequentially deposited from the inside to the outside. The specific preparation process is as follows:

### Step I . Preparation of first inorganic layer 31

The mixture of silicon oxide (SiO₂) and silicon nitride (Si₃N₄) was deposited and coated on the surface of the metal electrode layer by chemical vapor deposition (CVD) to form the first inorganic layer 31.

### Step II. Preparation of first organic thin film 32

The mixture of 9-dimethyl-4,7-diphenyl-1,10-phenanthroline (CAS: 4733-39-5) and 1,3,5-tris(1-phenyl-1H-benzimidazol-2-yl)benzene (CAS: 192198-85-9) was deposited and coated on the surface of the first inorganic layer 31 through an evaporation process to form the first organic thin film 32, wherein the evaporation speed was 2 Å/s, and the evaporation temperature was 200°C.

### Step III. Preparation of second inorganic layer 33

Aluminum oxide (Al₂O₃) was deposited and coated on the surface of the first organic thin film 32 by chemical vapor deposition (CVD) to form the second inorganic layer 33, that is, the encapsulation component 30 was prepared.

### Example 4

The example differs from Example 1 in that:
(1) The total number of layers of the encapsulation component 30 is 5 layers, including a first inorganic layer 31, a first organic thin film 32, a second inorganic layer 33, a second organic thin film 34, and a third inorganic layer 35 sequentially deposited from the inside to the outside, as shown in FIG. 2.

In particular, the first inorganic layer 31, the second inorganic layer 33, and the third inorganic layer 35 each have a thickness of 3 µm, and the first inorganic layer 31, the second inorganic layer 33, and the third inorganic layer 35 are each made of indium oxide (In₂O₃). The first organic thin film 32 and the second organic thin film 34 are each made of 6-fluoro-2-(2'-fluoro-[1,1'-biphenyl]-4-yl)-3-methylquinoline-4-carboxylic acid (CAS: 96187-53-0), and the first organic thin film 32 and the second organic thin film 34 each have a thickness of 500 nm.

(2) The examples of the present invention further provide a preparation method of an encapsulation component, which, on the basis of the encapsulated perovskite solar cell module of the example, includes: performing deposition and coating on a top of the perovskite solar cell module 20 in an alternating form of inorganic layer-organic layer-inorganic layer, with an outermost layer being an inorganic layer, the inorganic layer and the organic layerfinally deposited and coated on a surface of the perovskite solar cell module 20 is the encapsulation component 30. The total number of layers of the encapsulation component 30 of the example is 5 layers, including the first inorganic layer 31, the first organic thin film 32, the second inorganic layer 33, the second organic thin film 34, and the third inorganic layer 35 sequentially deposited from the inside to the outside. The specific preparation process is as follows:

### Step I . Preparation of first inorganic layer 31

Indium oxide (In₂O₃) was deposited and coated on the surface of the metal electrode layer by chemical vapor deposition (CVD) to form the first inorganic layer 31.

### Step II. Preparation of first organic thin film 32

6-fluoro-2-(2'-fluoro-[1,1'-biphenyl]-4-yl)-3-methylquinoline-4-carboxylic acid (CAS: 96187-53-0) was deposited and coated on the surface of the first inorganic layer 31 through an evaporation process to form the first organic thin film 32, wherein the evaporation speed was 2 Å/s, and the evaporation temperature was 200°C.

### Step III. Preparation of second inorganic layer 33

Indium oxide (In₂O₃) was deposited and coated on the surface of the first organic thin film 32 by chemical vapor deposition (CVD) to form the second inorganic layer 33.

### Step IV. Preparation of second organic thin film 34

6-fluoro-2-(2'-fluoro-[1,1'-biphenyl]-4-yl)-3-methylquinoline-4-carboxylic acid (CAS: 6187-53-0) was deposited and coated on the surface of the second inorganic layer 33 through an evaporation process to form the second organic thin film 34, wherein the evaporation speed was 2 Å/s, and the evaporation temperature was 200 °C.

### Step V. Preparation of third inorganic layer 35

Indium oxide (In₂O₃) was deposited and coated on the surface of the second organic thin film 34 by chemical vapor deposition (CVD) to form the third inorganic layer 35, that is, the encapsulation component 30 was prepared.

### Comparative Example 1

The comparative example differs from Example 1 in that the first inorganic layer 31 of the encapsulation component 30 has a thickness of 3 µm, and the second inorganic layer 33 has a thickness of 15 µm.

### Comparative Example 2

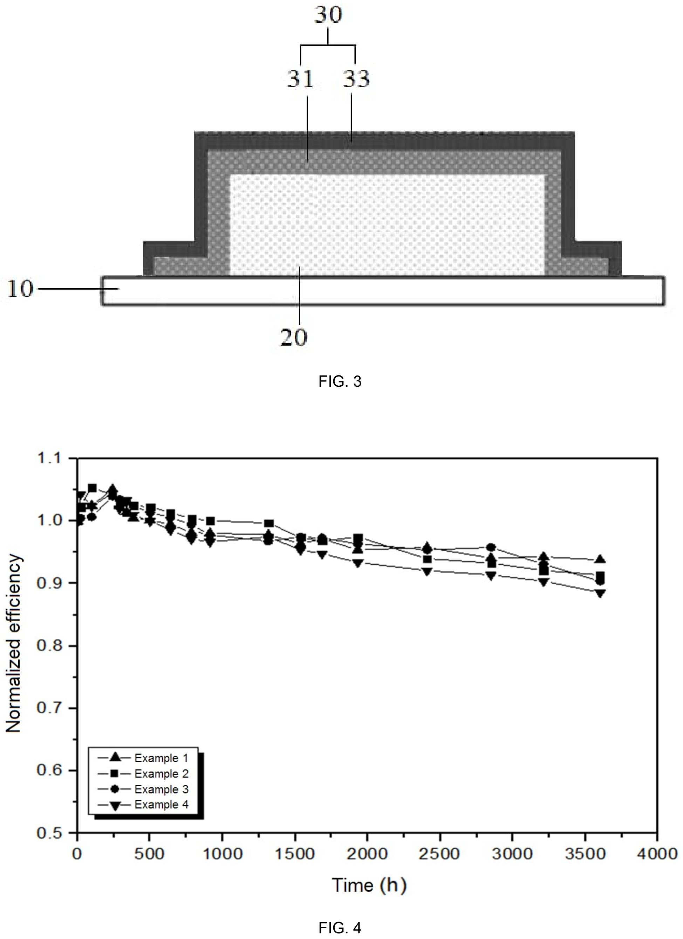

The comparative example differs from Example 1 in that the total number of layers of the encapsulation component 30 is 2 layers, including the first inorganic layer 31 and the second inorganic layer 33 sequentially deposited from the inside to the outside, and the encapsulation component 30 of the comparative example does not include an organic layer, as shown in FIG. 3.

To illustrate the efficacy of the present invention, device stability tests were conducted on the encapsulated perovskite solar cell assemblies in Examples 1 to 4 and Comparative Examples 1 to 2, with the detection method as follows:
The measurement was conducted using a solar simulator, with the illumination intensity of the solar simulator set to 100 mA/cm². The experimental conditions were illumination at atmospheric pressure, a temperature of 20 °C, and a humidity of 30%. The test result, i.e., the PCE-t curve (curve of the change of normalized efficiency over time), was obtained, as shown in FIG. 4.

From FIG. 4, it can be seen that the encapsulated perovskite solar cell modules of Examples 1 to 4 maintain an initial power conversion efficiency of 88% or more after 3600 h in an external air environment. Therefore, the encapsulation component 30 plays a crucial role in isolating moisture and oxygen and enhancing the stability of the cell module.

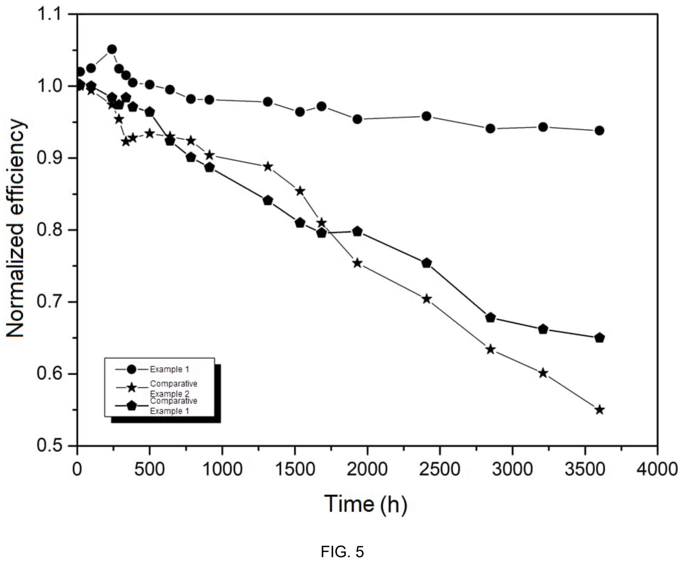

From FIG. 5, it can be seen that the encapsulated perovskite solar cell module prepared in Example 1 maintains an initial power conversion efficiency of about 90% after 3600 h in an external air environment, while the power conversion efficiency of the encapsulated perovskite solar cell module prepared in Comparative Example 1 drops to 70% or less of the initial value after 3600 h. Through the comparison of module stability, it can be observed that if the thickness of the inorganic layer is not within 5 nm to 10 µm, the subsequent encapsulating effect of the encapsulation component 30 on the perovskite solar cell module is poor, leading to a rapid decrease in the power conversion efficiency of the corresponding cell module. The encapsulation component 30 of Comparative Example 2 is encapsulated with only an inorganic layer, without an organic thin film to complement the inorganic layer. The power conversion efficiency of the encapsulated perovskite solar cell module drops to 55% of the initial value after 3600 h. Therefore, without an organic thin film as part of the encapsulation component 30, the encapsulating effect of the encapsulation component on the perovskite solar cell module is poor.

The description above is merely a specific embodiment of the present invention, which enables those skilled in the art to understand or implement the present invention. Various modifications to these examples are apparent to those skilled in the art, and the general principles defined herein is implemented in other examples without departing from the spirit or scope of the present invention.

It is to be understood that the present invention is not limited to what has been described above and that various modifications and changes can be made without departing from the scope. The scope of the present invention is limited only by the appended claims.

## Claims

1. An encapsulated perovskite solar cell module, comprising a substrate (10), a perovskite solar cell module (20), and an encapsulation component (30) sequentially stacked from bottom to top, wherein a lower surface of the encapsulation component (30) is in contact with an upper surface of the substrate (10) to form an encapsulated structure, and the perovskite solar cell module (20) is located within the encapsulated structure; and
the encapsulation component (30) comprises at least two inorganic layers and at least one organic layer, the at least two inorganic layers and the at least one organic layer are alternately stacked, and an outermost layer of the encapsulation component (30) is one of the at least two inorganic layers,
wherein each of the at least one organic layer is made of an organic molecular material through an evaporation process.

2. The encapsulated perovskite solar cell module according to claim 1, wherein a total number of layers of the encapsulation component (30) is N layers, N being an odd number, and 3 ≤ N ≤ 17.

3. The encapsulated perovskite solar cell module according to claim 1, wherein each of the at least one organic layer has a thickness of 500 nm to 50 µm.

4. The encapsulated perovskite solar cell module according to claim 1, wherein compounds comprised in the organic molecular material all contain heteroatoms, the heteroatoms being at least one of N and O; and
the compounds comprise 8-hydroxyquinoline aluminum, 9-dimethyl-4,7-diphenyl-1,10-phenanthroline, 1,3,5-tris(1-phenyl-1H-benzimidazol-2-yl)benzene, 2-(4-biphenyl)-5-phenyloxadiazole, 6-fluoro-2-(2'-fluoro-[1,1'-biphenyl]-4-yl)-3-methylquinoline-4-carboxylic acid, and at least one of the following formulas 1 to 6.

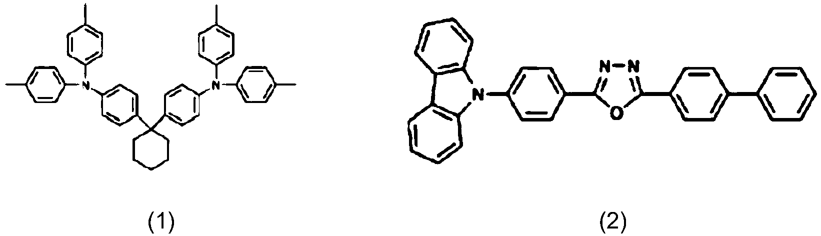

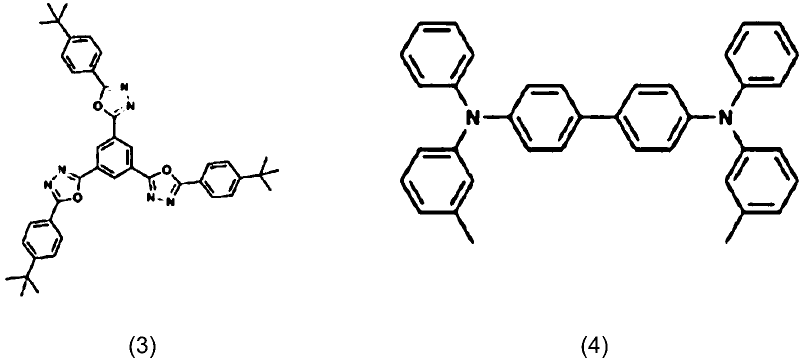

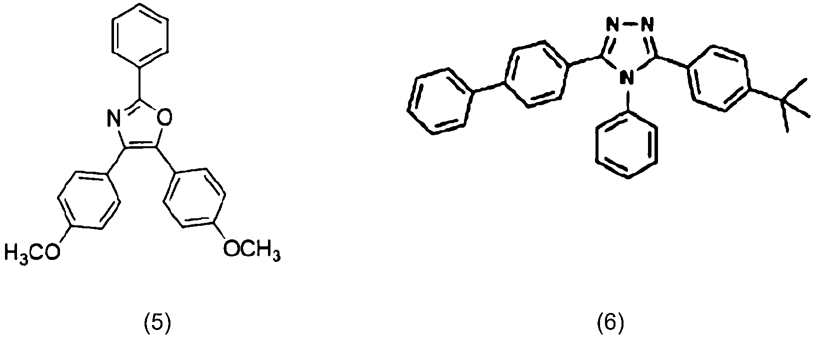

5. The encapsulated perovskite solar cell module according to claim 1, wherein each of the at least two inorganic layers has a thickness of 5 nm to 10 µm.

6. The encapsulated perovskite solar cell module according to claim 1, wherein each of the at least two inorganic layers is made of at least one of Siₓ₁O_{y1}, Siₓ₂N_{y2}, SiOₓ₃N_{y3}, ZnO, Sb₂O₃, Alₓ₄O_{y4}, In₂O₃, and SnO₂, wherein x1, x2, x3, x4, y1, y2, y3, and y4 are all integers in a range of 1 to 5.

7. The encapsulated perovskite solar cell module according to claim 1, wherein the perovskite solar cell module (20) comprises: a hole transport layer, a perovskite layer, an electron transport layer, and a metal electrode layer sequentially stacked from bottom to top, a lower surface of the hole transport layer being in contact with the upper surface of the substrate (10); or
an electron transport layer, a perovskite layer, a hole transport layer, and a metal electrode layer sequentially stacked from bottom to top, a lower surface of the electron transport layer being in contact with the upper surface of the substrate (10);
wherein one of the at least two inorganic layers on the outermost layer of the encapsulation component (10) is disposed on a top of the metal electrode layer, and a lower surface of the one of the at least two inorganic layers on the outermost layer of the encapsulation component (30) is in contact with the upper surface of the substrate (10), to encapsulate the perovskite solar cell module (20).

8. A preparation method of an encapsulation component, wherein on the basis of the encapsulated perovskite solar cell module according to any one of claims 1-7, the preparation method comprises: performing deposition and coating on a top of the perovskite solar cell module (20) in an alternating form of inorganic layer-organic layer-inorganic layer, with an outermost layer being an inorganic layer, inorganic layers and an organic layer finally deposited and coated on a surface of the perovskite solar cell module (20) forming the encapsulation component (30).

9. The preparation method of an encapsulation component according to claim 8, wherein each of the inorganic layers is formed by depositing and coating a material of the inorganic layer on the surface of the perovskite solar cell module (20) through a plasma deposition process or a vacuum deposition process.

10. The preparation method of an encapsulation component according to claim 8, wherein the organic layer is prepared by depositing and coating an organic molecular material on a surface of one of the inorganic layers through an evaporation process to form an organic thin film,
wherein during the evaporation process, an evaporation speed is 0.1 Å/s to 5 Å/s, and an evaporation temperature is 150°C to 400°C.
